# EUROPEAN PATENT APPLICATION

(11) **EP 1 457 269 A2**
(43) Date of publication of application: **15.09.2004**
(21) Application number: 04005622.8
(22) Date of filing: 09.03.2004
(51) Int. Cl.: B08B 3/08, B08B 3/04, B08B 3/12, B08B 3/02, B08B 1/04, H01L 21/00

(54) **Apparatus for cleaning a substrate having metal interconnects**

(30) Priority: 12.03.2003 JP 2003065845
(71) Applicant: EBARA CORPORATION, Ohta-ku, Tokyo (JP)
(72) Inventor: Kodera, Masako, Ohta-ku Tokyo (JP); Ito, Kenya, Ohta-ku Tokyo (JP); Kamezawa, Masayuki, Ohta-ku Tokyo (JP); Hamada, Satomi, Ohta-ku Tokyo (JP); Katakabe, Ichiro, Ohta-ku Tokyo (JP)
(74) Representative: Wagner, Karl H., Dipl.-Ing.

(57) **Abstract**

The present invention relates to a cleaning apparatus which can reduce a potential difference between metals or alloys used to form interconnects on a substrate for thereby minimizing corrosion which may occur during and after a substrate cleaning process. The cleaning apparatus for cleaning a substrate having metal interconnects comprises a cleaning mechanism for cleaning the substrate, and a functional water supply mechanism for supplying functional water to the cleaning mechanism. The cleaning mechanism cleans a surface of the substrate with use of the functional water.

## Description

### BACKGROUND OF THE INVENTION

### Field of the Invention:

The present invention relates to a cleaning apparatus for cleaning a substrate having metal interconnects for use in a precision electronic component such as a semiconductor device, and more particularly to a cleaning apparatus which can reduce a potential difference between metals or alloys used to form interconnects on a substrate for thereby minimizing corrosion which may occur during and after a substrate cleaning process.

### Description of the Related Art:

Aluminum (A1) has been widely used as an interconnect material in a semiconductor device. Aluminum or aluminum alloy is a base metal having an extremely low potential compared with other metals (see "Metal Guidebook", p 877, edited by The Japan Institute of Metals). Accordingly, when aluminum or aluminum alloy is used in combination with copper (Cu), tungsten (W), titanium (Ti), or their alloy, such aluminum or aluminum alloy is highly liable to suffer corrosion due to potential difference.

For example, Al-Cu alloy (aluminum and a small amount of copper added thereto) that is generally used in a semiconductor device has a surface potential of -730 mV (with respect to Ag/AgCl) in pure water. On the other hand, tungsten (W) has a surface potential of about -500 mV, titanium nitride (TiN) has a surface potential of -430 mV, and copper (Cu) has a surface potential of about -100 mV. Consequently, the potential difference of 200mV or more is generated between Al-Cu alloy and tungsten, the potential difference of 300 mV or more is generated between Al-Cu alloy and titanium nitride, and the potential difference of 600 mV is generated between Al-Cu alloy and copper.

Tungsten is widely used as a filling material for contact holes. Tungsten alloy and titanium alloy are used as a barrier metal, and copper is used as a main material for forming interconnects. Therefore, if aluminum or aluminum alloy which basically comprises Al-Cu, and the above metal such as tungsten, titanium, or copper, or their alloys are simultaneously exposed on a surface of a semiconductor device and such a semiconductor device is processed, aluminum or aluminum alloy which basically comprises Al-Cu is highly likely to suffer corrosion.

For example, in the case of forming aluminum interconnects by a damascene process, interconnect grooves are first formed on a surface of a silicon wafer, and then a metal serving as a barrier metal such as TiN and Ti is deposited on the surface of the silicon wafer by a sputtering process or the like to form a thin film, e.g., a laminated film of TiN and Ti. Thereafter, aluminum is deposited by a sputtering process or the like to form an aluminum film having a thickness greater than the depth of the interconnect grooves. Subsequently, aluminum and the barrier metal deposited on convex portions of the surface of the silicon wafer are removed by a CMP (Chemical Mechanical Polishing or Chemical Mechanical Planarization) process so as to allow aluminum and the barrier metal to remain only in the interconnect grooves, thereby forming aluminum interconnects.

After the CMP process, the silicon wafer having the aluminum interconnects is cleaned by a cleaning process. However, there arises a problem that the aluminum interconnects are corroded in the cleaning process. Specifically, the silicon wafer is generally cleaned with pure water. When the pure water is supplied to the aluminum interconnects and the barrier metal during the cleaning process, the aluminum interconnects suffer a serious problem in that the aluminum interconnects are corroded and dissolved due to the potential difference between the aluminum interconnects and the barrier metal which have been joined to each other. Such a problem is reported in a document titled "Met. Res. Soc. Symp. Proc.", Vol. 671, 2001, -Control of Pattern Specific Corrosion During Aluminum Chemical Mechanical Polishing-, written by H. Kim et. al.

Further, when aluminum interconnects are formed by an RIE (Reactive Ion Etching) process, it is necessary to remove residues, which remain on the substrate after the RIE process and a resist removing process, with use of a chemical liquid in a subsequent cleaning process. In this cleaning process also, the aluminum interconnects are corroded and dissolved because the aluminum interconnects and the barrier metal are simultaneously brought into contact with the chemical liquid and pure water that is used as a rinsing liquid.

If circuit interconnects formed on the substrate have a large width, the above problem of corrosion is not so serious. However, if the substrate has fine circuit interconnects thereon, then the corrosion may cause defects such as disconnection, and hence the above problem becomes serious.

### SUMMARY OF THE INVENTION

Therefore, there has been demand for a cleaning apparatus which can prevent interconnects made of aluminum or aluminum alloy on a substrate from being corroded, and it is an object of the present invention to provide such a cleaning apparatus.

Inventors of the present invention have made diligent studies in order to solve a problem of corrosion which occurs during a cleaning process of a substrate due to a potential difference between an interconnect metal such as aluminum or the like and a barrier layer metal on the substrate. As a result, the inventors have found that the potential difference between the interconnect metal and the barrier layer metal can be reduced by using various types of functional waters as cleaning waters for cleaning the substrate instead of using pure water, and have completed the present invention based on the findings in that the functional waters are effective to prevent the corrosion from proceeding.

According to an aspect of the present invention, there is provided a cleaning apparatus for cleaning a substrate having metal interconnects, comprising: a cleaning mechanism for cleaning the substrate; and a functional water supply mechanism for supplying functional water to the cleaning mechanism; wherein the cleaning mechanism cleans a surface of the substrate with use of the functional water..

In a preferred aspect of the present invention, the functional water supply mechanism produces gas-dissolved water as the functional water.

In a preferred aspect of the present invention, the functional water supply mechanism comprises a water electrolyzing device for electrolyzing water to produce electrolytic water as the functional water.

In a preferred aspect of the present invention, the cleaning mechanism comprises at least one of a mechanism having a cleaning member for scrubbing the surface of the substrate, a mechanism having a cleaning member which is rotated on the surface of the substrate, a mechanism for applying an ultrasonic wave to the functional water, a mechanism for generating cavitation in the functional water, and a mechanism for generating cavitation in the functional water and applying an ultrasonic wave to the functional water.

In a preferred aspect of the present invention, metal or ally for forming the metal interconnects contains at least one of aluminum, tungsten, and titanium nitride.

In a preferred aspect of the present invention, the functional water comprises gas-dissolved water containing at least one of CO₂ and O₃.

The functional water used as cleaning water comprises pure water in which a predetermined gas such as CO₂ gas or O₃ gas is dissolved.

The functional water can be produced by an electrolyzing process in which ultrapure water is electrolyzed without the addition of an electrolyte, and a gas-dissolving process in which a gas is dissolved in pure water with use of a gas-insufflating filter.

Examples of the functional water produced by the electrolyzing process include oxygen-gas-dissolved water (anode water) produced in an anode side and hydrogen-gas-dissolved water (cathode water) produced in a cathode side. The oxygen-gas-dissolved water produced in the anode side has a pH ranging from 6 to 7 and an oxidation-reduction potential ranging from 200 to 300 mV. The hydrogen-gas-dissolved water produced in the cathode side has a pH ranging from 7 to 8 and an oxidation-reduction potential ranging from -500 to -700 mV.

In the gas-dissolving process, a predetermined gas is blown into pure water to be dissolved therein, thus producing gas-dissolved water such as oxygen-gas-dissolved water, hydrogen-gas-dissolved water, and other-gas-dissolved water.

Examples of a gas to be dissolved include a carbon dioxide gas, an ozone gas, an ammonia gas, a hydrochloric acid gas, and the like, and two or more of these gases can be blown into pure water.

A potential of a metal used to form interconnects on a substrate can be shifted by using the functional water which has been thus produced. For example, although aluminum dipped in pure water has a surface potential of -1120 mV, aluminum dipped in gas-dissolved water containing an oxygen gas at saturated concentration has a surface potential of about -310 mV. In this manner, the surface potential of aluminum can be greatly shifted in the noble direction. Even if aluminum is dipped in gas-dissolved water containing an oxygen gas at non-saturated concentration, the surface potential of aluminum can be shifted in the noble direction.

When aluminum is dipped in hydrogen-gas-dissolved water having saturated concentration which is produced in the same process, the surface potential of aluminum is -770 mV, which is not shifted greatly. However, when aluminum is dipped in a liquid comprising a mixture of the oxygen-gas-dissolved water having saturated concentration and the hydrogen-gas-dissolved water having saturated concentration, the surface potential of aluminum is in the range of -200 to-300 mV, which is greatly shifted to the noble direction. In the case of using gas-dissolved water produced by blowing a gas with use of a gas-insufflating filter, the same result as described above can also be obtained. Even if oxygen-gas-dissolved water and hydrogen-gas-dissolved water each having non-saturated concentration are used, the surface potential of aluminum can be shifted in the noble direction.

As described above, it is possible to use functional water produced by blowing a gas other than oxygen and hydrogen, and one example of such functional water is carbon-dioxide-gas-dissolved water. The carbon-dioxide-gas-dissolved water does not have an ability to greatly shift the surface potential of aluminum. However, the carbon-dioxide-gas-dissolved water is practical for use because the carbon-dioxide-gas-dissolved water having a concentration of 3 ppm is capable of shifting the surface potential of aluminum, tungsten, tungsten alloy, titanium, and titanium alloy in the noble direction by a maximum of about 100 mV.

From the viewpoint of the potential difference between aluminum and another metal, the potential differences between aluminum and titanium and between aluminum and titanium alloy are minimized when using the oxygen-gas-dissolved water or a mixture of the oxygen-gas-dissolved water and the hydrogen-gas-dissolved water. Similarly, the oxygen-gas-dissolved water or a mixture of the oxygen-gas-dissolved water and the hydrogen-gas-dissolved water is effective for aluminum.

The gas-dissolved water including the functional water of the present invention has already been used to clean a substrate. For example, there has been known a process for cleaning a substrate with use of an aqueous solution in which any one of an hydrogen gas, a reducing gas, or an ozone gas is dissolved for the purpose of removing particles from the substrate after a resist removing process or the purpose of removing a metal impurity attached on the substrate. Such a process for cleaning the substrate with use of the aqueous solution is disclosed in the following documents: Japanese laid-open patent publication No. 10-64867, Japanese laid-open patent publication No. 10-172941, Japanese laid-open patent publication No. 2001-326209, Japanese laid-open patent publication No. 2002-100599, and Japanese laid-open patent publication No. 2002-118085.

However, the above documents do not disclose a process for cleaning a substrate having interconnects formed thereon, and do not suggest a method of controlling the potential difference between two or more metals or alloys for forming interconnects.

### BRIEF DESCRIPTION OF THE DRAWINGS

FIG. 1 is a schematic view showing a basic structure of a cleaning apparatus according to a first embodiment of the present invention;
FIG. 2 is a schematic view showing a basic structure of a cleaning apparatus according to a second embodiment of the present invention;
FIG. 3 is cross-sectional view showing an example of a cleaning module having a batch-type dipping container;
FIG. 4 is a schematic view showing an example of a spray-type cleaning module;
FIG. 5 is a schematic view showing a gas-dissolved-water producing unit;
FIG. 6 is a schematic view showing an electrolytic water producing unit;
FIG. 7 is a schematic view showing an example of a cleaning/drying module for performing a roll cleaning process while holding and rotating a substrate;
FIG. 8A is a perspective view showing another example of a cleaning/drying module for cleaning a substrate by supplying functional water as cleaning water;
FIG. 8B is a perspective view showing an essential part of the cleaning/drying module shown in FIG. 8A;
FIG. 9 is a perspective view showing another example of a cleaning/drying module having a pencil-type cleaner;
FIG. 10A is a schematic view showing a polishing apparatus which incorporates a cleaning apparatus according to the present invention; and
FIG. 10B is a perspective view showing an essential part of the polishing apparatus shown in FIG. 10A.

### DETAILED DESCRIPTION OF THE PREFERRED EMBODIMENTS

A cleaning apparatus for cleaning a substrate having metal interconnects formed thereon according to embodiments of the present invention will be described below.

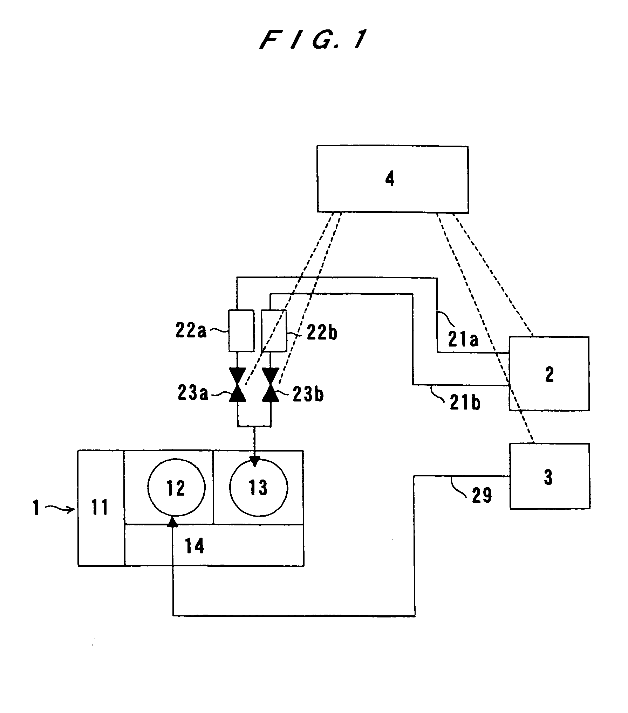

FIG. 1 is a schematic view showing a basic structure of a cleaning apparatus according to a first embodiment of the present invention. As shown in FIG. 1, a cleaning apparatus comprises a cleaning unit 1 serving as a cleaning mechanism, a functional water producing unit 2 serving as a functional water supply mechanism, a chemical liquid supply unit 3, a controller 4, a pair of functional water supply pipes 21a, 21b, a pair of flow meters 22a, 22b, a pair of valves 23a, 23b, and a chemical liquid supply pipe 29. The cleaning unit 1 comprises a loading/unloading unit 11, a chemical processing module 12, a cleaning/drying module 13, and a transfer module 14.

A substrate to be cleaned is introduced into the cleaning unit 1 through the loading/unloading unit 11. The substrate is processed, e.g. etched, in the chemical processing module 12, and is then cleaned and dried in the cleaning/drying module 13. The substrate which has been cleaned and dried is transferred to a subsequent process by the transfer module 14.

Specifically, a substrate having metal interconnects formed thereon is transferred to the chemical processing module 12, and is processed by a chemical liquid such as an etching liquid or a cleaning liquid that is supplied from the chemical liquid supply unit 3 through the chemical liquid supply pipe 29.

The substrate having the metal interconnects, which is an object to be cleaned, is then transferred to the cleaning/drying module 13. In the cleaning/drying module 13, the substrate is cleaned by functional water. The functional water is produced by the functional water producing unit 2 and supplied to the cleaning/drying module 13 through the functional water supply pipes 21a, 21b, the flow meters 22a, 22b, and the valves 23a, 23b. The valves 23a, 23b are controlled by the controller 4 so that the valves 23a, 23b are selectively opened and closed at an appropriate timing. In this cleaning process, it is possible to use not only a single type of functional water, but also several types of functional waters as cleaning waters.

For example, anode water may be used as first functional water, and then a mixture of anode water and cathode water may be used as second functional water. In such a case, first, the anode water and the cathode water as functional water are produced by the functional water producing unit 2. Then, only the anode water is supplied to the substrate through the functional water supply pipe 21a, the flow meter 22a, and the valve 23a, thereby cleaning the substrate for a predetermined period of time. Thereafter, the cathode water is supplied to the substrate through the functional water supply pipe 21b, the flow meter 22b, and the valve 23b, thereby cleaning the substrate. The types of the functional waters are not limited to the above case. For example, a combination of pure water and anode water or cathode water, a combination of anode water and cathode water, or a combination of electrolytic water such as anode water or cathode water and gas-dissolved water which is produced by introducing a gas into pure water may be used as the functional water.

Examples of a cleaning process using the functional water include a roll cleaning process in which a cleaning member scrubs the surface, to be cleaned, of the substrate, a pencil cleaning process in which a cleaning member is rotated on the surface, to be cleaned, of the substrate, a cavitation ultrasonic cleaning process, and a combination of these processes.

The cleaning/drying module 13 performs a contact-type cleaning process such as a roll cleaning process, a dipping process for dipping one or more substrates in the functional water held in a cleaning container (not shown), or a non-contact-type rinsing process for supplying the functional water to a surface, to be cleaned, of a substrate that is held by a substrate holding mechanism (not shown).

The supply of the chemical liquid, and the supply and switching of the cleaning water (the functional water) depending on a type of metal used for forming the interconnects on the surface of the substrate can be performed at appropriate timings by signals from the controller 4. The combination of the cleaning waters can be also made in appropriate composition by signals from the controller 4.

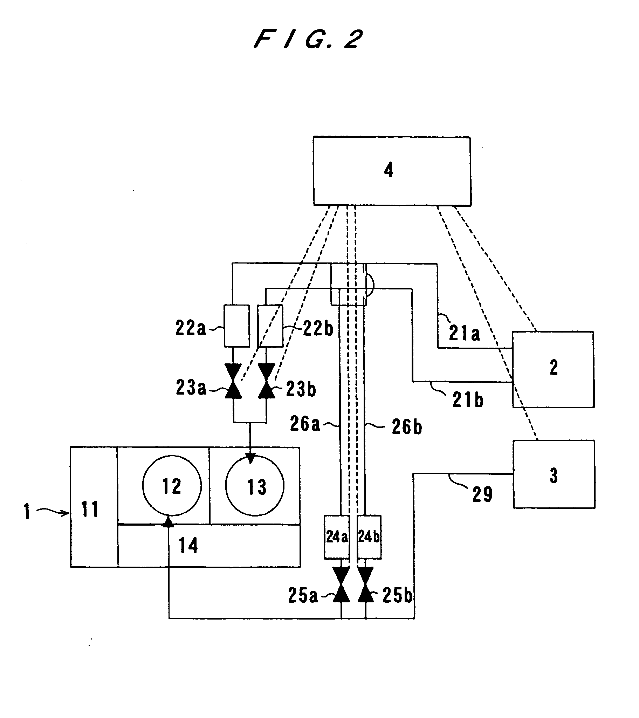

FIG. 2 is a schematic view showing a basic structure of a cleaning apparatus according to a second embodiment of the present invention. Structure and operation of the cleaning apparatus according to the second embodiment which will not be described below are identical to those of the cleaning apparatus according to the first embodiment.

As shown in FIG. 2, the cleaning apparatus comprises connecting pipes 26a, 26b, flow meters 24a, 24b, and valves 25a, 25b. The connecting pipes 26a, 26b connect the functional water supply pipes 21a, 21b and the chemical liquid supply pipe 29 to each other, and the flow meters 24a, 24b and the valves 25a, 25b are provided on the connecting pipes 26a, 26b, respectively. With this structure, the functional waters produced by the functional water producing unit 2 are supplied into the chemical liquid supply pipe 29 through the connecting pipes 26a, 26b, the flow meters 24a, 24b, and the valves 25a, 25b. The valves 25a, 25b are controlled by the controller 4 so that several types of the functional waters are selectively supplied into the chemical liquid supply pipe 29 through the connecting pipes 26a, 26b.

According to the cleaning apparatus shown in FIG. 2, it is possible to add the functions of the functional waters to the chemical liquid for thereby achieving a preferable processing condition, e.g., a preferable etching condition. As with the first embodiment, the supply of the chemical liquid, and the supply and switching of the functional water (the cleaning water) can be performed at appropriate timings by signals from the controller 4. The selection of the functional water to be added to the chemical liquid can be also performed by signals from the controller 4 to make appropriate composition.

An example of a cleaning apparatus for cleaning a substrate having metal interconnects according to the present invention comprises a substrate holding mechanism, a cleaning mechanism for cleaning the substrate, and a functional water supply mechanism for supplying functional water to the cleaning mechanism. The cleaning mechanism cleans a surface of the substrate with use of the functional water.

In this cleaning apparatus, the substrate having the metal interconnects formed on its surface is held by the substrate holding mechanism, and is transferred to the cleaning mechanism. The substrate holding mechanism is operable to move the substrate in an appropriate manner as needed while holding the substrate firmly. Specifically, the substrate holding mechanism may be operable to turn the substrate which has the metal interconnects formed on the surface thereof from a horizontal attitude to a vertical attitude, or may be operable to rotate the substrate about its own axis and move the substrate in a horizontal plane.

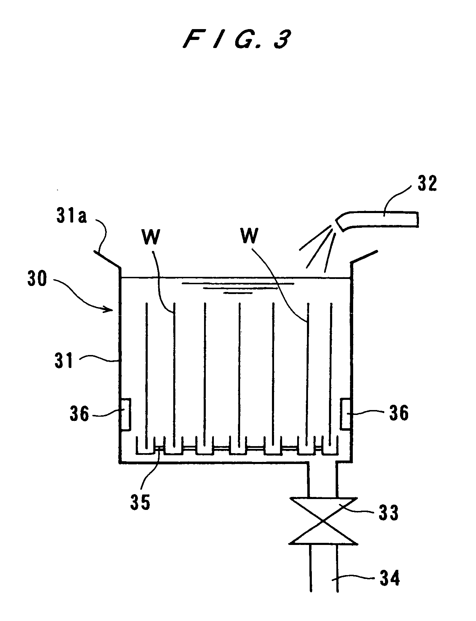

A substrate to be cleaned may be placed in a dipping container, and functional water may be supplied into the dipping container to clean the substrate. FIG. 3 is cross-sectional view showing an example of a cleaning module having a batch-type dipping container which is incorporated in the cleaning unit. As shown in FIG. 3, a cleaning module 30 comprises a dipping container 31, and a functional water supply nozzle 32 disposed above the dipping container 31. A drain pipe 34 is connected to a bottom of the dipping container 31, and a valve 33 is provided on the drain pipe 34. A substrate holder 35 for holding a plurality of substrates W is disposed in the dipping container 31. In the cleaning module 30 having the above structure, the plurality of substrates W are held by the substrate holder 35, and then the valve 33 is closed. Functional water is supplied from the functional water supply nozzle 32 into the dipping container 31 until the substrates W are fully dipped in the functional water. The substrates W are kept being dipped in the functional water for a predetermined period of time. During this period of time, an upper open end 31a of the dipping container 31 may be hermetically closed or covered with a lid (not shown). Alternatively, the functional water may be overflowed from the dipping container 31. Particularly, if the functional water comprises hydrogen-gas-dissolved water, the hydrogen-gas-dissolved water should preferably be overflowed from the dipping container 31 because hydrogen tends to be easily released from the water. Ultrasonic vibrators 36 may be provided in the dipping container 31 so that ultrasonic waves are applied to the functional water for thereby increasing a cleaning efficiency. In FIG. 3, the drain pipe 34 is connected to the bottom of the dipping container 31. However, the dipping container 31 may be constructed so as to allow the functional water to be overflowed from the upper open end 31a. In this case, a stock container (not shown) for temporarily holding the functional water which has overflowed from the dipping container 31 may be provided.

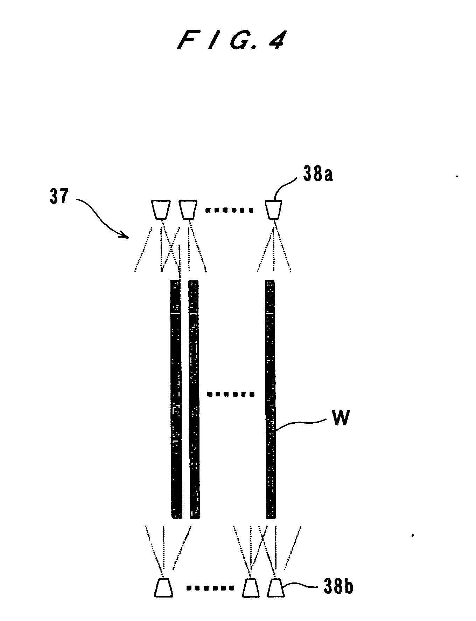

FIG. 4 is a schematic view showing an example of a spray-type cleaning module which is incorporated in the cleaning unit. As shown in FIG. 4, a cleaning module 37 comprises a plurality of nozzles 38a, 38b. The nozzles 38a are disposed above a plurality of substrates W which have been transferred by a transfer mechanism (not shown), and the nozzles 38b are disposed below the substrates W. Functional waters are supplied from the nozzles 38a, 38b to the substrates W to clean the substrates W. The nozzles 38a, 38b may supply the functional water in the form of a liquid shower or in the form of a mist spray. Either the substrates W or the nozzles 38a, 38b or both the substrates W and the nozzles 38a, 38b may be moved relatively to each other during the cleaning process. Alternatively, both the substrates W and the nozzles 38a, 38b may not be moved.

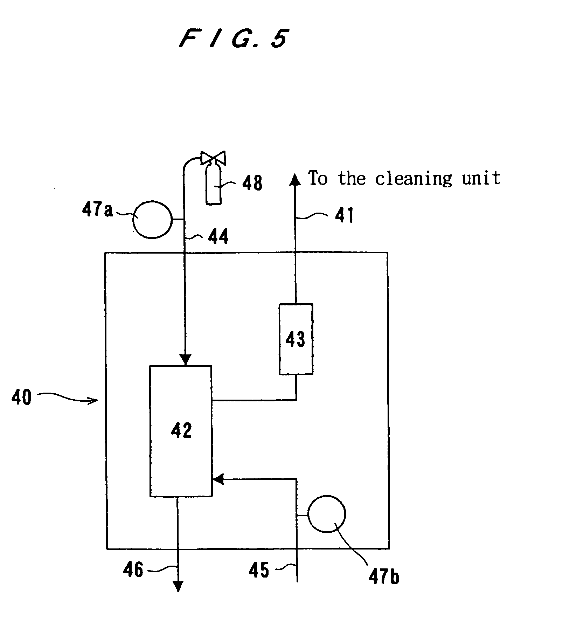

FIG. 5 is a schematic view showing a gas-dissolved-water producing unit for producing gas-dissolved-water as an example of the functional water producing unit 2. As shown in FIG. 5, a gas-dissolved-water producing unit 40 comprises a gas dissolving device 42. A predetermined gas is supplied to the gas dissolving device 42 through a gas supply pipe 44 and pure water is also supplied to the gas dissolving device 42 through a pure water supply pipe 45. The gas dissolving device 42 mixes the gas and the pure water to produce gas-dissolved water serving as functional water, which is supplied to the cleaning unit 1 (see FIG. 1 or FIG. 2) through a gas-dissolved-water supply pipe 41. The gas dissolving device 42 comprises a gas dissolving membrane in the form of a hollow yarn membrane made of polytetrafluoroethylene. The gas supply pipe 44 is connected to a gas container 48 such as a hydrogen gas container or an oxygen gas container. A pressure meter 47a is provided on the gas supply pipe 44, although it is possible to dispense with the pressure meter 47a. A pressure meter 47b is provided on the pure water supply pipe 45, and a flow meter 43 for measuring a flow rate of the gas-dissolved water is provided on the gas-dissolved water supply pipe 41. It is also possible to dispense with the pressure meter 47b and the flow meter 43. A drain pipe 46 is connected to the gas dissolving device 42 for discharging the pure water and the gas from the gas dissolving device 42.

In the gas-dissolved-water producing unit 40, the pure water and the gas are brought into contact with each other through the gas dissolving membrane to produce the gas-dissolved water. In the gas dissolving device 42, the gas and the pure water should preferably flow countercurrently.

When the pure water and the gas are brought into contact with each other, the pressure of the pure water should preferably be slightly higher than the pressure of the gas because it is possible to prevent gas bubbles from being produced in the vicinity of the gas dissolving membrane, thereby easily controlling the concentration of the gas which is dissolved in the pure water. In the gas-dissolved-water producing unit 40 shown in FIG. 5, the gas is supplied from the gas container 48. However, the gas may be supplied from a pipe system in a plant.

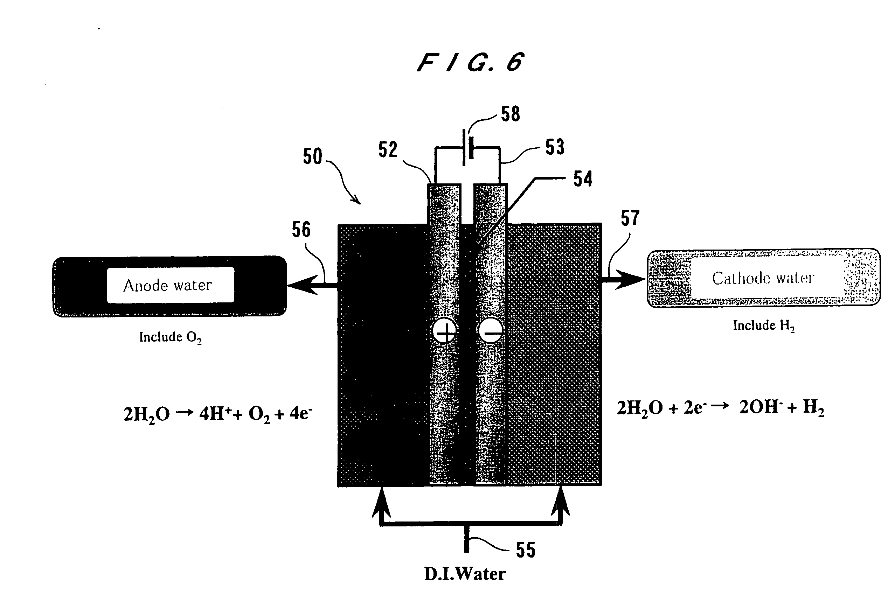

FIG. 6 is a schematic view showing an electrolytic water producing unit as another example of the functional water producing unit 2. An electrolytic water producing unit 50 serving as a water electrolyzing device comprises an electrolytic bath 51 for holding water, e.g., pure water or ultrapure water, which is divided into two regions by an ion exchange membrane 54. An anode electrode 52 is disposed in one of the regions, and a cathode electrode 53 is disposed in the other. A power supply 58 is connected to the anode electrode 52 and the cathode electrode 53 for electrolyzing the water held in the electrolytic bath 51. An anode water pipe 56 is connected to the electrolytic bath 51 for extracting anode water which has been produced in the electrolytic bath 51, and a cathode water pipe 57 is connected to the electrolytic bath 51 for extracting cathode water which has been produced in the electrolytic bath 51. A deionized water supply pipe 55 is connected to the electrolytic bath 51 for supplying deionized water, e.g., pure water or ultrapure water, into the electrolytic bath 51 so as to compensate for a shortage of water in the electrolytic bath 51.

The ion exchange membrane 54 may comprise a cation exchange membrane or an anion exchange membrane. However, the ion exchange membrane 54 should preferably comprise a cation exchange membrane. Each of the anode electrode 52 and the cathode electrode 53 should preferably comprise an electrode made of insoluble metal such as platinum or titanium, or an electrode whose surface is covered with such insoluble metal.

When the cleaning apparatus described above is used to clean a substrate having aluminum interconnects after the substrate is polished by a CMP process, operation is carried out as follows: The substrate which has been polished by the CMP process using slurry is water-polished using the functional water immediately after the CMP process. Thereafter, the substrate is cleaned with use of one or more scrubbers, rolls, or pencil-type cleaners. Alternatively, the substrate is cleaned by a non-contact-type cleaning process such as a rinsing process. In the scrubbing and/or the rinsing process, it is effective to use the functional water.

If oxygen-gas-dissolved water and hydrogen-gas-dissolved water are used as functional water, aluminum interconnects can be prevented from being corroded substantially completely.

If the present invention is applied to clean a substrate having aluminum interconnects after a RIE process, it is effective to use oxygen-gas-dissolved water or both oxygen-gas-dissolved water and hydrogen-gas-dissolved water in order to prevent the aluminum interconnects from being corroded.

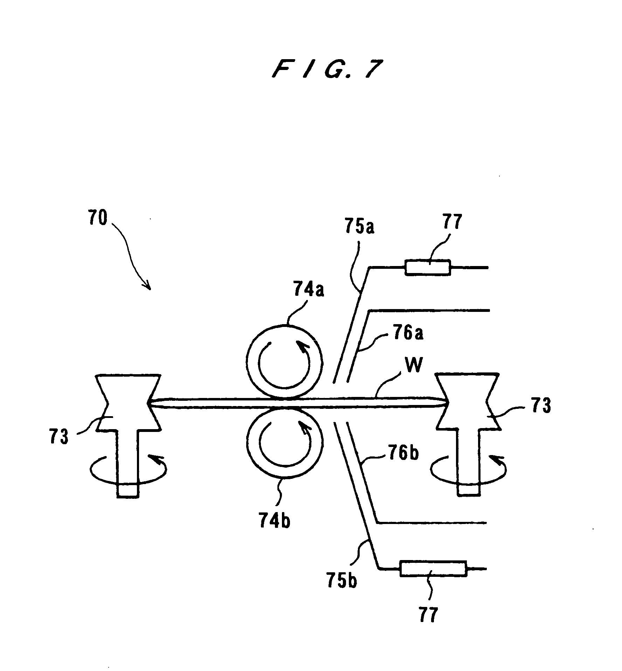

FIG. 7 is a schematic view showing an example of a cleaning/drying module incorporated in the cleaning apparatus according to the first or second embodiment of the present invention. A cleaning/drying module 70 shown in FIG. 7 performs a roll cleaning process while holding and rotating a substrate having interconnects. As shown in FIG. 7, the cleaning/drying module 70 comprises a plurality of rollers 73a, 73b for holding and rotating a substrate W, a plurality of roll-shaped cleaning members 74a, 74b for cleaning the substrate W, functional water supply nozzles 75a, 75b for supplying functional water to the substrate W, and chemical liquid supply nozzles 76a, 76b for supplying a chemical liquid such as an etching liquid or a chemical cleaning liquid to the substrate W. The rollers 73a, 73b hold a circumferential edge of the substrate W and rotate the substrate W about its own axis in a horizontal plan. The roll-shaped cleaning members 74a, 74b are brought into contact with an upper surface and a lower surface of the substrate W, respectively, and are rotated about their own axes to scrub the upper surface and the lower surface of the substrate W. Each of the roll-shaped cleaning members 74a, 74b comprises a PVA sponge roll, for example. The functional water supply nozzles 75a, 75b are disposed above and below the substrate W, respectively. The chemical liquid supply nozzles 76a, 76b are also disposed above and below the substrate W, respectively. Necessary functional water is supplied from the functional water supply nozzles 75a, 75b to the substrate W. Necessary chemical liquid is supplied from the chemical liquid supply nozzles 76a, 76b to the substrate W. The functional water should preferably be supplied from the functional water supply nozzles 75a, 75b as quickly as possible after the functional water is produced by the functional water producing unit 2 (see FIG. 1 or FIG. 2) in order to prevent the functional water from being deteriorated, i.e., being reduced in concentration. For this reason, a pipe for interconnecting the functional water producing unit 2 and the cleaning/drying module 70 should be as short in length as possible. Furthermore, this pipe should preferably be made of polytetrafluoroethylene.

Ultrasonic vibrators 77 may be provided on the respective functional water supply nozzles 75a, 75b as needed. Each of the ultrasonic vibrators 77 applies ultrasonic energy to the functional water to increase a cleaning capability. If necessary, the functional water producing unit 2 (see FIG. 1 or FIG. 2) should preferably have a measuring device (not shown) for measuring and monitoring properties such as a pH and an ion concentration of the functional water and a control device (not shown) for controlling such properties based on values measured by the measuring device.

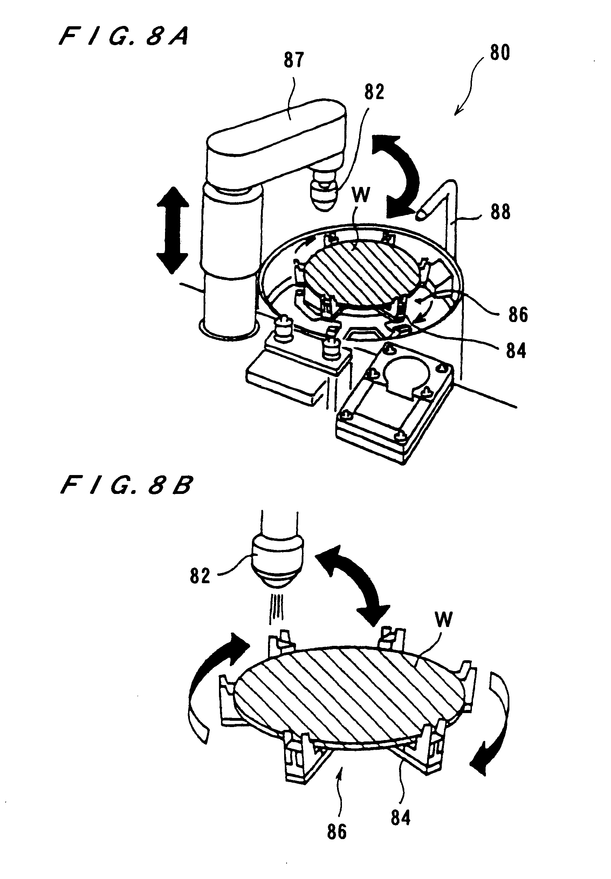

FIG. 8A is a perspective view showing another example of a cleaning/drying module incorporated in the cleaning apparatus according to the first or second embodiment of the present invention. FIG. 8B is a perspective view showing an essential part of the cleaning/drying module shown in FIG. 8A. A cleaning/drying module 80 shown in FIGS. 8A and 8B has a mechanism for cleaning a substrate W by supplying a cleaning liquid onto the substrate W. As shown in FIGS. 8A and 8B, the cleaning/drying module 80 comprises a plurality of substrate holding arms 84 for holding the substrate W, a rotational table 86 for rotating the substrate W, a liquid supply nozzle 82 for supplying a liquid onto the substrate W, a swing arm 87 which performs a swinging motion, and a gas supply nozzle 88 for supplying a gas to the substrate W so as to dry the substrate W.

In the cleaning/drying module 80, the substrate W is held by the substrate holding arms 84 and rotated by the rotational table 86 which is rotatable at a high rotational speed. The liquid supply nozzle 82 is mounted on the swing arm 87. A chemical liquid such as an etching liquid or a chemical cleaning liquid is supplied from the liquid supply nozzle 82 to the upper surface of the substrate W, thereby processing the substrate W. In addition, functional water as a cleaning liquid or a rinsing liquid is also supplied from the liquid supply nozzle 82 to the upper surface of the substrate W, thereby cleaning the substrate W. If necessary, the chemical liquid, the functional water, and the rinsing liquid are vibrated by ultrasonic wave having a high frequency in the range of several tens kHz to 5 MHz.

The liquid supply nozzle 82 may comprise a nozzle for supplying the above liquid having a high pressure in the range of 1 × 10⁶ to 5 × 10⁶ Pa. Alternatively, the liquid supply nozzle 82 may comprise a low-pressure-liquid nozzle and a high-pressure-liquid nozzle disposed centrally in the low-pressure-liquid nozzle for generating cavitation due to shear between a high-pressure liquid and a low-pressure liquid ejected from the respective nozzles. In this case, the high-pressure liquid has a pressure ranging from 1×10⁶ to 5 × 10⁶ Pa, and the low-pressure liquid has a pressure ranging from 1 × 10⁵ to 5 × 10⁵ Pa, for example. The functional water described above may be used for at least one of the high-pressure liquid and the low-pressure liquid. After the substrate W is cleaned, the supply of the cleaning liquid, the rinsing liquid, or the like from the liquid supply nozzle 82 is stopped, and then the rotational table 86 is rotated at a high rotational speed of 2000 rpm (min⁻¹) or more for thereby centrifugally drying the substrate W.

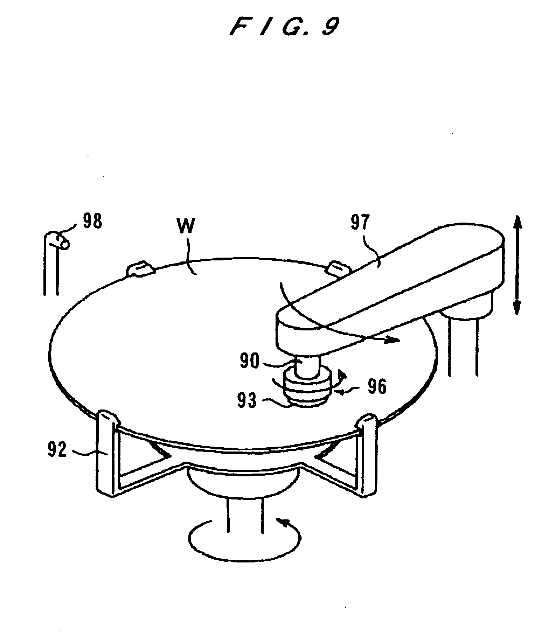

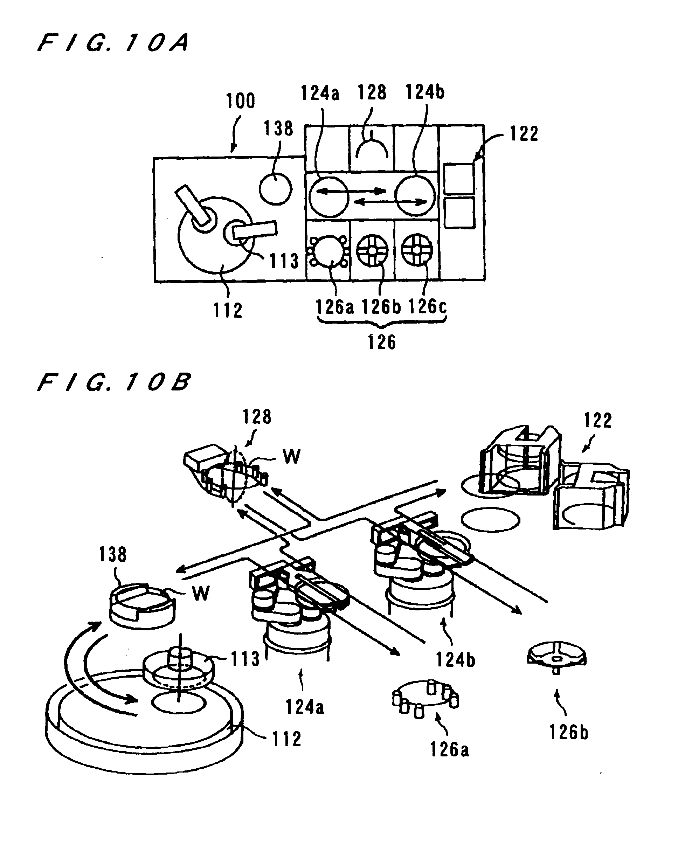

The substrate W is cleaned in a non-contact manner in the cleaning/drying module 80 shown in FIGS. 8A and 8B. However, the substrate W may be cleaned alternatively or additionally by a pencil-type cleaner which performs a rotational motion on the surface, to be cleaned, of the substrate W. FIG. 9 is a perspective view showing a cleaning/drying module having such a pencil-type cleaner. In FIG. 9, a semiconductor substrate W to be cleaned is transferred by a transfer robot, which will be described later on in FIGS. 10A and 10B, to a position above a spin chuck 92, and held by the spin chuck 92 in such a state that the surface, to be cleaned, of the substrate W faces upwardly. Then, the spin chuck 92 is rotated at a predetermined rotational speed to rotate the substrate W, and at the same time, functional water is supplied from a functional water supply nozzle 98 toward a substantially central portion of the substrate W.

A pencil-type cleaner 96 is mounted on a swing arm 97 via a rotational shaft 90. The pencil-type cleaner 96 has a cleaning member 93 comprising a PVA sponge or the like and being mounted on the pencil-type cleaner 96. The swing arm 97 is operable to perform a swinging motion and a vertical motion. The cleaning unit performs a cleaning process as follows: The swing arm 97 is swung to bring the pencil-type cleaner 96 to a position above a substantially central portion of the substrate W. At this time, the pencil-type cleaner 96 is not rotated. Then, the swing arm 97 is moved downwardly to bring the cleaning member 93 of the pencil-type cleaner 96 into contact with the upper surface of the substrate W. Immediately before the cleaning member 93 is brought into contact with the substrate W, the pencil-type cleaner 96 starts to be rotated about the rotational shaft 90 at a predetermined rotational speed. The cleaning member 93 is rotated independently of the substrate W which is being rotated by the spin chuck 92, and is pressed against the surface, to be cleaned, of the substrate W by the swing arm 97 under a predetermined pressing force. Then, the swing arm 97 is swung to bring the cleaning member 93 to the circumferential edge of the substrate W at a predetermined speed, thereby scrubbing the substrate W.

FIG. 10A is a schematic view showing a polishing apparatus which incorporates a cleaning apparatus according to the present invention. FIG. 10B is a perspective view showing an essential part of the polishing apparatus shown in FIG. 10A. The polishing apparatus shown in FIGS. 10A and 10B serves to polish and planarize a substrate W having a conductive material such as a metal interconnect material or an insulating material, which is formed on the surface of the substrate W by a CVD apparatus or a plating apparatus (not shown). The polishing apparatus has a polishing unit 100, a loading/unloading unit 122, two transfer mechanisms (transfer robots) 124a, 124b, a cleaning unit (cleaning mechanism) 126 having three cleaning modules 126a, 126b and 126c, and a reversing machine 128. The cleaning modules 126a, 126b and 126c may comprise a roll cleaning mechanism as shown in FIG. 7, a cleaning mechanism which employs a pencil-type cleaner as shown in FIG. 9, and a cleaning mechanism for supplying a cleaning liquid as shown in FIGS. 8A and 8B, respectively.

The substrate W is processed in the polishing apparatus as follows: The transfer mechanism 124b transfers the substrate W from the loading/unloading unit 122 to the reversing machine 128. The substrate W is reversed by the reversing machine 128 in such a state that a surface to be polished faces downwardly. The reversed substrate W is then transferred by the transfer mechanism 124a to a substrate-transfer base 138. The substrate W is placed on the substrate-transfer base 138 and is then held by a top ring 113 under vacuum. The substrate W is pressed against a polishing pad attached on a polishing table 112 under a predetermined pressing force. At this time, the top ring 113 and the polishing table 112 are moved, e.g., rotated, relatively to each other while a polishing liquid is supplied onto the polishing table 112, thus polishing the substrate W.

The polished substrate W is transferred to the substrate-transfer base 138 by the top ring 113, and then transferred from the substrate-transfer base 138 to the cleaning module 126a by the transfer mechanism 124a. The cleaning module 126a, which may comprise a roll cleaning mechanism, for example, cleans the substrate W with use of the functional water of the present invention. The substrate W which has been cleaned by the cleaning module 126a is then transferred by the transfer mechanism 124a to the cleaning module 126b and the cleaning module 126c in this order, where the substrate W is cleaned with use of the functional water. The cleaning module 126c rotates the cleaned substrate W at a high rotational speed, thereby spin-drying the substrate W.

The cleaned and dried substrate W is transferred to the loading/unloading unit 122 by the transfer mechanism 124b, and is accommodated in a cassette (not shown). The cleaning unit 126 is supplied with the functional water of the present invention as a cleaning liquid from the functional water producing unit (see FIG. 1 or FIG. 2) for thereby preventing the substrate W from being corroded when the substrate W is cleaned after being polished. The polishing liquid used in the polishing unit 100 comprises an alkaline liquid referred to as slurry, a colloid, or abrasive particles. Therefore, distribution of the functional water or a type of gas to be dissolved in the functional water can be changed to selectively supply the functional water to the cleaning module 126a and the subsequent cleaning modules 126b, 126c. A cleaning capability of the functional water of the present invention varies depending on a temperature of the functional water at the time of being supplied to the substrate. Therefore, a device (not shown) for measuring a temperature of the functional water and a device (not shown) for controlling a temperature of the functional water may be provided in the functional water producing unit or the functional water supply pipe (see FIG. 1 or FIG. 2).

As described above, according to the present invention, functional water such as gas-dissolved water is used instead of pure water so as to shift a surface potential of one or more metals or alloys for forming a circuit on a substrate, thereby preventing the metal from being corroded.

If the functional water of the present invention comprises oxygen-gas-dissolved water or hydrogen-gas dissolved water, then since both of the oxygen-gas-dissolved water and the hydrogen-gas dissolved water are neutral, the substrate does not need to be rinsed with pure water after being cleaned with the oxygen-gas-dissolved water or the hydrogen-gas dissolved water. Further, even if the substrate is rinsed with pure water after being cleaned with gas-dissolved water such as oxygen-gas-dissolved water or hydrogen-gas dissolved water, the substrate is not corroded by the pure water because the surface of the metal has been passivated by oxygen contained in the gas-dissolved water.

Furthermore, according to the present invention, it is possible to shift not only a surface potential of a metal, but also a surface potential of a silicon substrate or a glass. Particularly, gas-dissolved water with two or more gases dissolved therein is effective in minimizing any damage to the substrate which may occur in the case where only a single gas such as a hydrogen gas, a reducing gas, or an ozone gas is dissolved in the gas-dissolved water.

An example of the present invention will be described below. However, the present invention should not be interpreted as being limited to the example described below.

Measurement of potentials of metals in functional waters:

Potentials of Al (aluminum), TiN (titanium nitride), and W (tungsten) were measured when these metals are dipped in several types of functional waters. The measured potentials are shown in Table 1 below. Potential differentials between the above metals which are derived from the measured potentials are shown in Table 2 below.

**Table 1**

| | Metal potential (when stable) [mV] | | |
|---|---|---|---|
| Functional water | Al | TiN | W |
| Deionized water | -1120 | -430 | -490 |
| Anode water | -310 | -280 | -220 |
| Cathode water | -770 | -450 | -290 |
| Mixed water | -264 | -290 | -250 |

**Table 2**

| | Potential difference between metals [mV] | |
|---|---|---|
| Functional water | Al-TiN | Al-W |
| Deionized water | -690 | -628 |
| Anode water | -30 | -90 |
| Cathode water | -320 | -480 |
| Mixed water | 26 | -14 |

As can be seen from the results shown in Table 1, it is possible to shift the surface potential of the metal by selecting the functional water to be used for cleaning the metal. In addition, as can be seen from the results shown in Table 2, it is possible to reduce the potential difference between the metals by selecting the functional water in accordance with a combination of the metals. Therefore, it is possible to prevent the metal from being corroded when the metal is cleaned.

The cleaning apparatus according to the present invention is effective in preventing corrosion which may occur due to the potential difference between different types of metals such as a circuit-forming metal and a barrier metal by selecting functional water as cleaning water. Therefore, a base metal such as aluminum having a low potential can be used for forming fine interconnects on a substrate, thus allowing a highly integrated circuit to be formed on the substrate.

## Claims

1. A cleaning apparatus for cleaning a substrate having metal interconnects, comprising:
a cleaning mechanism for cleaning the substrate; and
a functional water supply mechanism for supplying functional water to said cleaning mechanism;
wherein said cleaning mechanism cleans a surface of the substrate with use of the functional water.

2. A cleaning apparatus according to claim 1, wherein said functional water supply mechanism produces gas-dissolved water as the functional water.

3. A cleaning apparatus according to claim 1 or 2, wherein said functional water supply mechanism comprises a water electrolyzing device for electrolyzing water to produce electrolytic water as the functional water.

4. A cleaning apparatus according to claim 1, wherein said cleaning mechanism comprises at least one of a mechanism having a cleaning member for scrubbing the surface of the substrate, a mechanism having a cleaning member which is rotated on the surface of the substrate, a mechanism for applying an ultrasonic wave to the functional water, a mechanism for generating cavitation in the functional water, and a mechanism for generating cavitation in the functional water and applying an ultrasonic wave to the functional water.

5. A cleaning apparatus according to claim 1, wherein metal or ally for forming the metal interconnects contains at least one of aluminum, tungsten, and titanium nitride.

6. A cleaning apparatus according to claim 2, wherein the functional water comprises gas-dissolved water containing at least one of CO₂ and O₃.
